# EUROPEAN PATENT APPLICATION

(11) **EP 1 583 151 A2**
(43) Date of publication of application: **05.10.2005**
(21) Application number: 05252003.8
(22) Date of filing: 30.03.2005
(51) Int. Cl.: H01L 27/146

(54) **Active pixel having buried transistor**

(30) Priority: 30.03.2004 US 816071
(71) Applicant: OmniVision Technologies, Inc., California 94089 (US)
(72) Inventor: He, Xinping, San Jose, California 95148 (US)
(74) Representative: Hackney, Nigel John

(57) **Abstract**

A reader for an RFID system includes an internal power source, a signal generator (24) for generating a detection signal containing analog data and an excitation signal, a transmitting antenna for receiving a transponder data signal from a transponder (12) containing digital data. Receiver electronics (26) are coupled with the receiving antenna for conditioning the transponder data signal before reading the digital data. The reader further includes a single-chip microcontroller (28) coupled with the internal power source and the receiver electronics (26). The single-chip microcontroller (28) has an analog to digitsl converter (42) to measure the declining power level of the internal power source and to acquire the analog data from the detection signal and the digital data from the transponder data signal. The single-chip microcontroller also includes a firmware and/or software-based demodulator for demodulating the transponder data signal to read the digital data.

## Description

The present invention relates to image sensors and more particularly to a CMOS image sensor that uses a buried transistor (MOSFET) to minimize 1/f noise.

CMOS image sensors have become ubiquitous. They are widely used in digital still cameras, security cameras, cellular phones, medical, and automobile applications. The technology used to manufacture CMOS image sensors has continued to advance at great pace. For example, the demands of higher resolution and lower power consumption have encouraged the further miniaturization and integration of the image sensor. As the pixels in the image sensors become smaller and smaller, the associated active elements within the pixels, such as the various transistors, also become smaller.

One result of this increased integration is the effect of 1/f noise. As the transistors in each of the pixels become smaller, 1/f noise becomes more of a concern. It is believed that the 1/f noise (also referred to as "flicker noise") is caused by switching transistors through the introduction of oxide traps at the surface, which act to trap and detrap electrons. As applied to the transistors used in an active pixel of a CMOS image sensor, the switching on and off of the various transistors will cause 1/f noise within the pixel.

Aspects of the present invention are set out in the accompanying claims.

### BRIEF DESCRIPTION OF THE DRAWINGS

Figure 1 is a schematic diagram of a prior art three transistor active pixel used in a CMOS image sensor.
Figure 2 is a schematic diagram of a prior art four transistor active pixel used in a CMOS image sensor.
Figure 3 is a schematic diagram of a three transistor active pixel formed in accordance with the present invention.
Figure 4 is a schematic diagram of a four transistor active pixel formed in accordance with the present invention.

### DETAILED DESCRIPTION

In the following description, numerous specific details are provided to provide a thorough understanding of embodiments of the invention. One skilled in the relevant art will recognize, however, that the invention can be practiced without one or more of the specific details, or with other methods, components, materials, etc. In other instances, well-known structures, materials, or operations are not shown or described in detail to avoid obscuring aspects of the invention.

Reference throughout this specification to "one embodiment" or "an embodiment" means that a particular feature, structure, or characteristic described in connection with the embodiment is included in at least one embodiment of the present invention. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

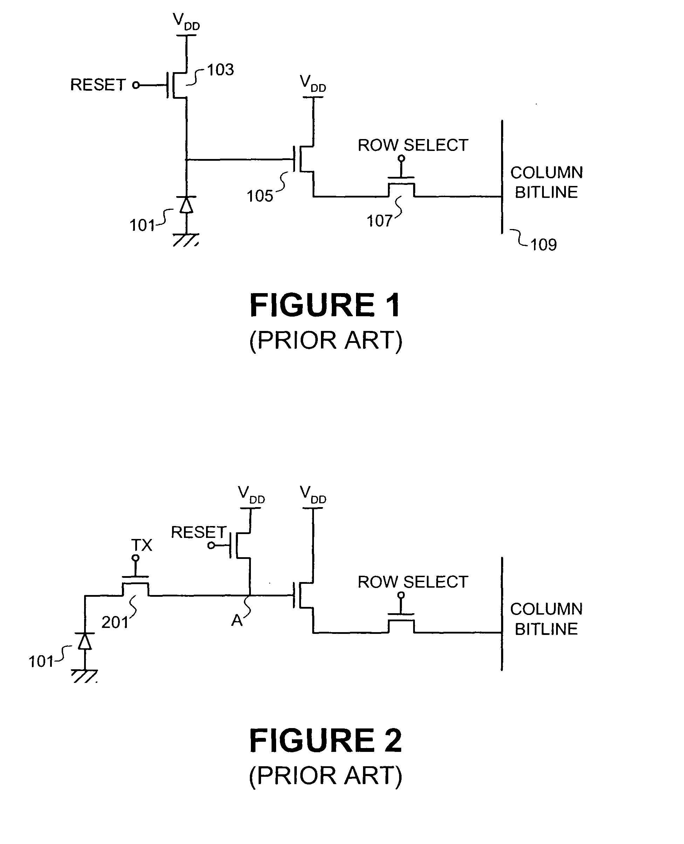

Figure 1 illustrates a prior art CMOS active pixel that uses three transistors. A light sensing element 101 outputs a signal that is used to modulate an amplification transistor 105. The amplification transistor is also known as a source-follower transistor. The light sensing element 101 can be one of a variety of devices, including without limitation, photogates, photodiodes, pinned photodiodes, partially pinned photodiodes, etc.

During an integration period, the light sensing element 101 captures light and outputs a signal indicative of the amount of light incident onto that light sensing element 101. The signal is used to modulate the amplification transistor 105. After the integration period, a reset transistor 103 is used to reset the level of the light sensing element output node to a reference level. Finally, a row select transistor 107 is used as a means to address the pixel and to selectively read out the signal from the pixel onto a column bit line 109.

Figure 2 is similar in many respects to the three transistor active pixel of Figure 1, except that an additional transfer transistor 201 is used to transfer the signal output by the light sensing element 101 to a floating node A. Although a four transistor active pixel may be larger in size because of the transfer gate 201, advantages relative to the three transistor active pixel of Figure 1 are still gained.

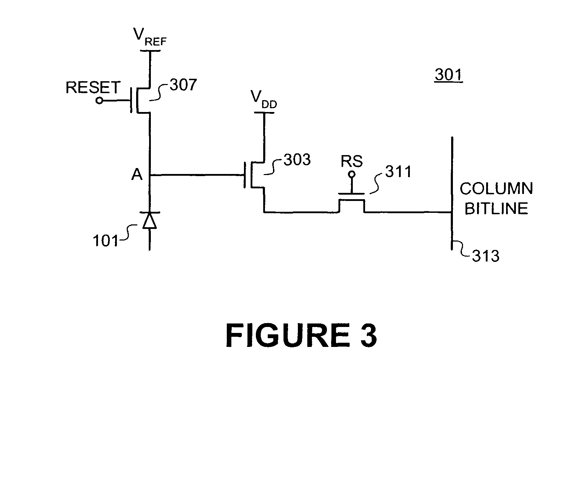

Turning to Figure 3, a three transistor active pixel 301 formed in accordance with the present invention is shown. In this active pixel, a light sensing element 101 (which includes without limitation photogates, photodiodes, pinned photodiodes (sub-species of photodiodes), partially pinned photodiodes (sub-species of photodiodes), and the like) has its output connected directly to an amplification transistor 303. The gate of the amplification transistor 303 is also referred to as sense node A.

As seen in Figure 3, the overall structure of the active pixel of the present invention is similar to that of the prior art shown in Figure 1. However, one important distinction between the present invention and the prior art is that one or more of the transistors located in the active pixel are formed to have some, most, or all of the source to drain current flow not at the surface (as is the case with conventional enhancement mode transistors), but rather flow through the body of the transistor below the surface. By having the current flow through the body of the transistor, the surface oxide traps are avoided.

There are several possible transistor devices that may be suitable. For example, a depletion mode transistor may be used. Alternatively, a buried transistor may be used. Still alternatively, various types of back biasing may be used to encourage current to flow through the body of the transistor and not the surface. Any current or future devices that routes current through the body of the transistor and not the surface is within the scope of this invention and may be utilized. This is referred to herein as a "body current" device.

As noted above, one alternative is the use of buried transistors. Thus, either the amplification transistor, the reset transistor 307, or the row select transistor 311, or all of them, may be implemented as a buried transistor. Typically, the greatest advantage is obtained when the amplification transistor is substituted with a "body current" device, such as a buried transistor or depletion mode transistor.

There are various methods of implementing a buried transistor, such as the use of silicon on insulator technology, and any of the methods would be suitable for the present invention. For example, the techniques disclosed in U.S. Patent Application Publication No. 2004/0036114 or U.S. Patent Application Publication No. 2002/0185684 provide examples of how buried transistors may be formed. While these pending applications are simply two examples of how buried transistors may be formed, any of the myriad of methods for forming a buried transistor may be used and implemented in the present invention.

It has been discovered by the inventor that the use of a buried transistor, such as for the amplification transistor 303, significantly reduces 1/f noise. Therefore, the use of buried transistors in the active pixels provides an advantage over the prior art. Note that the operation of the active pixel is substantially similar to a normal three or four transistor pixel.

Specifically, once the signal from the light sensing element 101 has been placed onto the sense node A, operation of the active pixel is similar to that of Figures 1 and 2. In other words, the signal on the sense node A is periodically reset using the reset transistor 307. Further, the signal on the sense node is used to modulate the amplification transistor 303 to output an amplified signal onto the column bitline 313. The row select transistor 311 is used to selectively address the pixel.

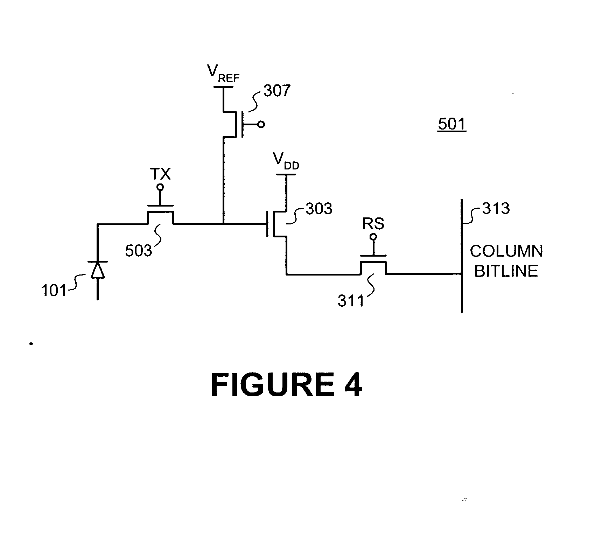

Turning now to Figure 4, a schematic view of a four transistor active pixel is shown. Similar to the description with respect to Figure 3, a buried transistor is utilized for the amplification transistor 303 and may optionally be utilized for the reset transistor 307 or row select transistor 311. Furthermore, the transfer transistor 503 may also be implemented as a buried transistor.

It can be appreciated that what is shown in Figures 3-4 is but one pixel in an array of pixels that form an image sensor. In many embodiments, the number of pixels in the image sensor array can range from hundreds of pixels to millions of pixels. Typically, the image sensor array has many pixels arranged as rows and columns. However, the teachings of the present invention can be utilized in a variety of architectures.

The description of the invention and its applications as set forth herein is illustrative and is not intended to limit the scope of the invention. Variations and modifications of the embodiments disclosed herein are possible, and practical alternatives to, or equivalents of the various elements, of the embodiments are known to those of ordinary skill in the art. Further, the various doping types may be reversed, such that an n-channel transistor described above may be replaced with a p-channel transistor. These and other variations and modifications of the embodiments disclosed herein may be made without departing from the scope and spirit of the invention.

## Claims

1. An active pixel comprising:
a light sensing element formed in a semiconductor substrate;
a sense node in electrical communication with said light sensing element for outputting a signal produced by said light sensing element;
an amplification transistor controlled by said sense node, wherein said amplification transistor is a buried transistor formed in said semiconductor substrate.

2. The pixel of Claim 1 wherein said light sensing element is selected from the group of photodiode, pinned photodiode, partially pinned photodiode, or photogate.

3. The pixel of Claim 1 further including a transfer transistor operative to transfer said signal from said light sensing element to said sense node.

4. The pixel of Claim 1 wherein said amplification transistor outputs an amplified version of said signal to a column bitline.

5. The pixel of Claim 1 further including a reset transistor operative to reset said sense node to a reference voltage.

6. The pixel of Claim 1 wherein said buried transistor is replaced with a depletion mode transistor.

7. An active pixel for use in a CMOS image sensor comprising:
a light sensing element formed in a semiconductor substrate;
a sense node;
a transfer transistor operative to transfer a signal produced by said light sensing element to said sense node; and
an amplification transistor controlled by said sense node, wherein said amplification transistor is a body current transistor formed in said semiconductor substrate.

8. The pixel of Claim 7 wherein said light sensing element is selected from the group of photodiode, pinned photodiode, partially pinned photodiode, or photogate.

9. The pixel of Claim 7 wherein said transfer transistor is implemented as a buried transistor.

10. The pixel of Claim 7 wherein said amplification transistor outputs an amplified version of said signal to a column bitline.

11. The pixel of Claim 7 further including a reset transistor operative to reset said sense node to a reference voltage.

12. The pixel of Claim 7 wherein said body current transistor is a buried transistor or a depletion mode transistor formed in said semiconductor substrate.
